# EUROPEAN PATENT APPLICATION

(11) **EP 0 665 649 A2**
(43) Date of publication of application: **02.08.1995**
(21) Application number: 95300576.6
(22) Date of filing: 30.01.1995
(51) Int. Cl.: H03K 17/22

(54) **Improvements in or relating to power controller circuits**

(30) Priority: 28.01.1994 US 189028
(71) Applicant: TEXAS INSTRUMENTS INCORPORATED, Dallas Texas 75265 (US)
(72) Inventor: Stein, Dale P., Sherman, Texas 75090-1820 (US)
(74) Representative: Blanco White, Henry Nicholas

(57) **Abstract**

A power-up-three-state voltage controller circuit has a source of a first transistor 235 connected to a reference node, a first end of a first resistor 221 connected to a drain and a gate of the first transistor 235, a first end of a second resistor 211 connected to a second end of the first resistor 221, a second end of the second resistor 211 connected to a voltage source, a gate of a second transistor 251 connected to the second end of the first resistor 221, a drain of the second transistor 251 connected to an output line 261, and a source of the second transistor 251 connected to the reference node.

## Description

### FIELD OF THE INVENTION

This invention generally relates to electronic systems and in particular it relates to power-up-three-state controller circuits.

### BACKGROUND OF THE INVENTION

In systems where circuits on many different boards have outputs and inputs attached to a common bus, it is desirable to not have the bus disturbed by the outputs of a circuit-board as it is first powering up. This can occur when the power supply for one set of boards ramps up at a different rate than others, or when a new circuit-board is inserted or removed while the system is running. The way to guarantee that outputs of each integrated circuit on a circuit-board will not affect the bus during power-up or power-down is to insure that they are all in the high-impedance state when the voltage on the power supply (Vcc) pins is below a prescribed level. When the Vcc voltage is above the prescribed level, the IC's will be able to function normally, and their outputs will be driven to the proper values determined by the function of each IC. A single control circuit is needed on each IC to sense the level of the voltage on the Vcc pin and produce a controlling signal that changes state when the prescribed Vcc voltage level is reached. This internal control signal is then fed into the output enable/disable drivers that in turn control the state of the IC's output buffers.

Circuits have been designed in MOS technology to sense the level of the Vcc voltage as it is ramping up or down and produce a control signal for enabling or disabling the output buffers. However, the problem in designing one of these is that of precisely positioning the point at which the internal control signal switches. When the temperature of the IC changes, or the manufacturing process yields transistors of a different strength, the point at which the internal control signal switches will change, and it may switch too early or too late. This is a very serious problem. In one case, the supply voltage on the IC may not be enough for the IC to function correctly, and the outputs of the IC could temporarily drive the system bus to the wrong state. In another case, the Vcc supply voltage on the IC may be sufficient for the IC to function, but the outputs of the IC might remain in the high-impedance state and not be able to control the bus. Some of the latest IC's operate at 3.0 volts, and a 3-volt range is too small to use the prior art power-up-three-state control circuits.

### SUMMARY OF THE INVENTION

Generally, and in one form of the invention, a power voltage controller circuit has a source of a first transistor connected to a reference node, a first end of a first resistor connected to a drain and a gate of the first transistor, a first end of a second resistor connected to a second end of the first resistor, a second end of the second resistor connected to a voltage source, a gate of a second transistor connected to the second end of the first resistor, a drain of the second transistor connected to an output line, and a source of the second transistor connected to the reference node.

This invention provides several advantages. One advantage of this invention is that it has a very small range of variation of the switching point of the control signal when temperature and process variations occur, and it can be used in the latest 3-volt integrated circuits.

### BRIEF DESCRIPTION OF THE DRAWINGS

In the drawings:
FIG. 1 is a schematic diagram of a prior art power-up-three-state controller circuit;
FIG. 2 is a schematic diagram of a preferred embodiment improved power-up-three-state controller circuit having tighter control over temperature and process variations;
FIG. 3 is a waveform diagram showing the performance of a prior art circuit like that of FIG. 1; and
FIG. 4 is a waveform diagram showing the performance of the preferred embodiment circuit of FIG. 2.

### DETAILED DESCRIPTION OF PREFERRED EMBODIMENTS

The preferred embodiment is an integrated circuit (IC) invention designed in MOS technology for precisely controlling the point at which the outputs of an integrated circuit make the transition from the high-impedance state (Z-state) to the normal operating state (a driven High or driven Low) as a result of the power supply voltage (Vcc) ramping from zero volts to its final operating value.

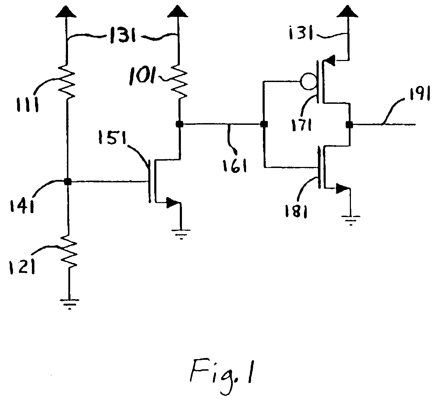

Many prior art power-up-three-state circuits employ some sort of voltage-divider supplied by Vcc. In the prior art circuit shown in FIG. 1, resistor 111 and resistor 121 form the voltage-divider that is supplied by Vcc node 131. Also, resistor 111 and resistor 121 connect at node 141 to the gate of NMOS transistor 151. The drain of NMOS transistor 151 connects to resistor 101 at node 161. Resistor 101 connects to Vcc at node 131. The drain of NMOS transistor 151 also connects to the gate of PMOS transistor 171 and the gate of NMOS transistor 181 at node 161. Transistor 171 and transistor 181 form an inverter whose output is node 191. This inverter is used merely for buffering and proper polarity of the output signal. The signal at node 191 is the controlling signal that feeds the enable/disable drivers for all the outputs on an integrated circuit.

An example of the component values for the prior art circuit of FIG. 1 is as follows. Resistor 111 is 40 kilo ohms. Resistor 121 is 50 kilo ohms. Resistor 101 is 150 kilo ohms. Transistor 151 has a channel width of 10 micrometers and a channel length of 1 micrometer. Transistor 171 has a channel width of 25 micrometers and a channel length of 1 micrometer. Transistor 181 has a channel width of 10 micrometers and a channel length of 1 micrometer.

In FIG. 1, the size of resistor 111 and size of resistor 121 are chosen such that, as Vcc node 131 is ramped from 0 volts to a final operating value, the voltage on node 141 will rise from 0 volts to a voltage higher than the threshold voltage of NMOS transistor 151. When the voltage on node 141 equals the threshold voltage of transistor 151, transistor 151 begins to turn on, switching the voltage on node 161 from the present level of Vcc node 131 down to 0 volts. The inverter formed by transistor 171 and transistor 181 produces a controlling signal at node 191 that switches from 0 volts up to the present level of Vcc node 131. As the voltage level of Vcc node 131 continues to rise, node 191 simply follows it. When Vcc node 131 is ramped from its normal operating value down to 0 volts, transistor 151 will turn off when the voltage on node 141 goes below the threshold voltage of transistor 151. This will switch the voltage on node 161 from 0 volts to the present level of Vcc node 131. Then the voltage at node 191 will switch from the level of Vcc node 131 down to 0 volts.

If the temperature changes, or the transistor strengths (resulting from the manufacturing process) change, the point in time corresponding to a particular Vcc level at which node 191 signal switches will also change. This is due to the fact that the threshold of NMOS transistor 151 varies with temperature and drive-current (Ids) strength. With a wide range of temperatures and Ids strengths, transistor 151 will have a turn-on point that varies over a wide range during the Vcc node 131 ramp. If the turn-on point varies over a wide range of Vcc voltage, it becomes increasingly more difficult to use such a circuit on an IC that operates at a low voltage like 3.0 volts. There simply isn't as much room to operate between 0 volts and 3 volts as there is between 0 volts and 5 volts.

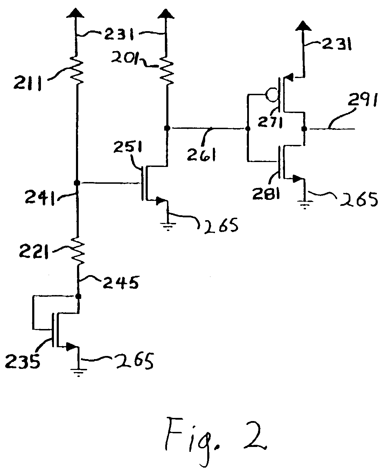

FIG. 2 shows the schematic of a preferred embodiment circuit that solves the problem of wide variation in the switching point of the NMOS transistor 251 when temperature and process variations occur. In FIG. 2, resistor 211 and resistor 221 form part of the voltage-divider that is supplied by Vcc (voltage source) node 231. Some CMOS manufacturing processes implement these resistors by using MOS transistors, but other types of resistors can also be used. Now a new element, NMOS transistor 235, is connected into the bottom of the voltage-divider at node 245. Note that the gate and drain of NMOS transistor 235 are connected together. The source of transistor 235 is connected to reference node 265. Resistor 211 and resistor 221 connect together at node 241 with the gate of NMOS transistor 251. The drain of NMOS transistor 251 connects to resistor 201 at node 261. Resistor 201 connects to Vcc at node 231. The source of transistor 251 connects to reference node 265. The drain of NMOS transistor 251 connects at node 261 to the gate of PMOS transistor 271 and the gate of NMOS transistor 281. The source of transistor 271 connects to Vcc at node 231. The drain of transistor 271 is connected to the drain of transistor 281. The source of transistor 281 is connected to reference node 265. Transistor 271 and transistor 281 form an inverter whose output is node 291. The controlling signal at node 291 may feed one or more CMOS inverters for more buffering or for producing the required polarity and drive strength.

An example of the component values for the preferred embodiment circuit of FIG. 2 is as follows. Resistor 211 is 120 kilo ohms. Resistor 221 is 17 kilo ohms. Resistor 201 is 150 kilo ohms. Transistor 251 has a channel width of 12 micrometers and a channel length of 3 micrometers. Transistor 235 has a channel width of 150 micrometers and a channel length of 1 micrometer. Transistor 271 has a channel width of 10 micrometers and a channel length of 1 micrometer. Transistor 281 has a channel width of 10 micrometers and a channel length of 1 micrometer.

What is unique about the preferred embodiment circuit of FIG. 2 is the use of NMOS transistor 235 in the voltage-divider. By connecting its gate and drain together and placing it in series with resistor 221, the voltage-divider now compensates for changes in threshold voltage (Vtsat) of NMOS transistor 251 over temperature and process variations. The Vtsat of transistor 235 is used to generate an "offset" for the voltage that develops across resistor 221 of the voltage-divider. When conditions are such that the Vtsat of transistor 251 is lower, the Vtsat of transistor 235 is also lower, and a lower voltage is developed at node 241 of the voltage-divider. When conditions are such that the Vtsat of transistor 251 is higher, the Vtsat of transistor 235 is also higher, and a higher voltage results at node 241 of the voltage-divider. The effect is that transistor 251 turns on at nearly the same place during a ramp of Vcc node 231 over the entire range of expected temperatures and manufacturing process variations.

Three additional design considerations are worth noting about the circuit in FIG. 2. Transistor 235 has a large channel width-to-length ratio, and transistor 251 has a comparatively very small channel width-to-length ratio. This insures that the Vtsat of transistor 235 is smaller than the Vtsat of transistor 251. This is absolutely necessary, because the voltage provided to the gate of transistor 251 (node 241) is the sum of the voltage developed across resistor 221 and the Vtsat of transistor 235. Secondly, it is desirable that the delta between the Vtsat of transistor 251 and the Vtsat of transistor 235 be rather large, so that the size of resistor 221 can be as large as possible. The reason for this is not readily apparent, but stems from the fact that, as the resistor-divider ratio (the size of resistor 221 divided by the sum of the sizes of resistor 211 and resistor 221) increases, the slope of the voltage waveform at node 241 when Vcc (node 231) is ramped becomes steeper. A steeper slope of the voltage waveform at node 241 results in a tighter spread of the turn-on points of transistor 251 over temperature and manufacturing process variations. The third design consideration worth noting is that, while maintaining the relatively small width-to-length ratio that is required for transistor 251, both the channel width and channel length of transistor 251 are made large enough that width-reduction and length-reduction on that transistor due to the manufacturing process will be small percentages of the width and length respectively.

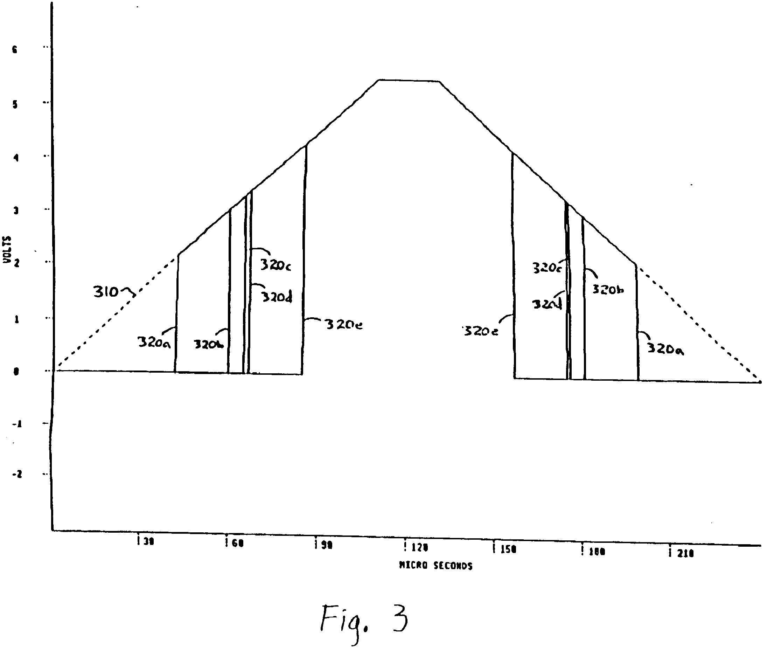

FIG. 3 shows waveforms from simulations of the performance of a typical power-up-three-state controller circuit like that of FIG 1. Voltage is plotted along the vertical axis and time is plotted along the horizontal axis. Waveform 310, shown with a dashed line, is the power supply voltage like that of Vcc at node 131 in FIG. 1. It ramps from 0 volts up to a final operating value of 5.5 volts to simulate a powering-up condition, and then ramps from 5.5 volts down to 0 volts to simulate a powering-down condition. The waveforms 320 (a through e), shown with solid lines, are the responses of the controlling signal (like node 191 in FIG. 1) at five different points over the entire range of expected temperature and process variations. Notice that waveform 320a switches when Vcc is around 2.1 volts, and waveform 320e switches when Vcc is around 4.3 volts, giving a spread of 2.2 volts over the temperature and process variations. The specification for some IC's is that these waveforms switch between Vcc = 2.2 volts (minimum) and Vcc = 4.4 volts (maximum). These waveforms fail this minimum specification, and there is virtually no guardband to the specification.

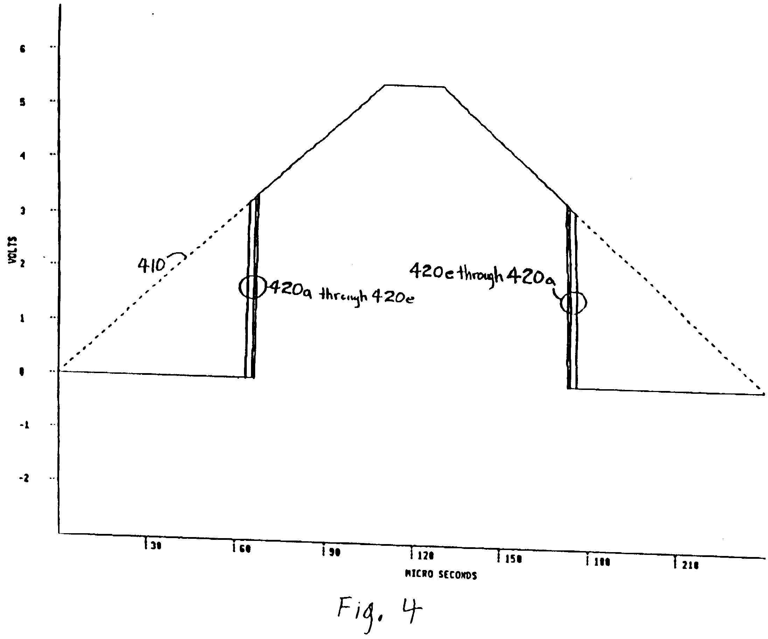

Compare the waveforms of FIG. 4 to those of FIG. 3. The waveforms in FIG. 4 are from simulations of the performance of the preferred embodiment power-up-three-state controller circuit of FIG. 2. As before, the dashed line, waveform 410, is the power supply voltage on Vcc node 231 in FIG. 2. The waveforms 420 (a through e), shown with solid lines, are the responses of the controlling signal (node 291 in FIG. 2) over the same range of expected temperature and process variations. Notice that now all of the waveforms 420 (a through e) switch when Vcc is around 3.3 volts, and there is only a 0.15-volt spread over the temperature and process variations. With such a small voltage spread, a circuit of the type shown in FIG. 2 also lends itself nicely to use in the latest 3-volt integrated circuits.

This invention provides several advantages. One advantage of this invention is that it has a very small range of variation of the switching point of the control signal when temperature and process variations occur, and it can be used in the latest 3-volt integrated circuits.

A preferred embodiment has been described in detail hereinabove. It is to be understood that the scope of the invention also comprehends embodiments different from that described, yet within the scope of the claims.

While this invention has been described with reference to an illustrative embodiment, this description is not intended to be construed in a limiting sense. Various modifications and combinations of the illustrative embodiment, as well as other embodiments of the invention, will be apparent to persons skilled in the art upon reference to the description. It is therefore intended that the appended claims encompass any such modifications or embodiments.

## Claims

1. A power voltage controller circuit comprising:
a first transistor, a source of the first transistor connected to a reference node;
a first resistor, a first end of the first resistor connected to a drain and a gate of the first transistor;
a second resistor, a first end of the second resistor connected to a second end of the first resistor, and a second end of the second resistor connected to a voltage source; and
a second transistor, a gate of the second transistor connected to the second end of the first resistor, a drain of the second transistor connected to an output line, and a source of the second transistor connected to the reference node.

2. The circuit of claim 1, wherein the circuit is in the form of a power-up-three stage voltage controller circuit.

3. The circuit of claim 1 or claim 2, wherein the first transistor has a smaller threshold voltage than the second transistor.

4. The circuit of any preceding claim , wherein the first transistor is an NMOS transistor.

5. The circuit of claim 4, wherein the second transistor is an NMOS transistor.

6. The circuit of claim 5, wherein the first transistor has a larger channel width-to-length ratio than the second transistor.

7. The circuit of any preceding claim, further comprising a third resistor, a first end of the third resistor connected to the drain of the second transistor, and a second end of the third resistor connected to the voltage source.

8. The circuit of claim 7, further comprising an inverter connected to the output line.

9. The circuit of claim 8, wherein the inverter comprises:
a third transistor, a gate of the third transistor connected to the output line, a source of the third transistor connected to the voltage source, and a drain of the third transistor provides a control signal output; and
a fourth transistor, a gate of the fourth transistor connected to the output line, a drain of the fourth transistor connected to the drain of the third transistor, and a source of the fourth transistor connected to the reference node.

10. The circuit of any preceding claim, wherein the source voltage is ramped over a voltage range between about 0 volts and about 5.5 volts.

11. The circuit of claim 10, wherein the second transistor is turned on when the source voltage is between about 3.2 and about 3.4 volts.

12. The circuit of any of claims 1 to 9, wherein the source voltage is ramped between about 0 volts and about 3 volts.

13. The circuit of any preceding claim, wherein the first resistor has a value of 120 kilo Ohms.

14. The circuit of any preceding claim, wherein the second resistor has a value of 17 kilo Ohms.

15. The circuit of any preceding claim, wherein the first transistor has a channel width of 150 micrometers and a channel length of 1 micrometer.

16. The circuit of any preceding claim, wherein the second transistor has a channel width of 12 micrometers and a channel length of 3 micrometers.

17. A method for providing a control signal for controlling when outputs of an integrated circuit make a transition from a high-impedance state to a normal operating state comprising:
coupling a source of a first transistor to a reference node;
coupling a first end of a first resistor to a drain and a gate of the first transistor;
coupling a first end of a second resistor to a second end of the first resistor;
coupling a second end of the second resistor to a voltage source;
coupling a gate of a second transistor to the second end of the first resistor;
coupling a source of the second transistor to the reference node; and
providing the control signal from a drain of the second transistor.

18. The method of claim 17, further comprising coupling the drain of the second transistor to a first end of a third resistor.

19. The method of claim 18, further comprising coupling a second end of the third resistor to the voltage source.

20. The method of claim 19, further comprising coupling the control signal to an inverter.
